# EUROPEAN PATENT APPLICATION

(11) **EP 2 207 200 A1**
(43) Date of publication of application: **14.07.2010**
(21) Application number: 08291240.3
(22) Date of filing: 24.12.2008
(51) Int. Cl.: H01L 21/98, H01L 25/10

(54) **Stack of molded integrated circuit dies with side surface contact tracks**

(71) Applicant: NXP B.V., 5656 AG Eindhoven (NL)
(72) Inventor: The designation of the inventor has not yet been filed
(74) Representative: Hardingham, Christopher Mark

(57) **Abstract**

A method of forming electrical connections on an integrated circuit package, the method comprising: providing a cuboid-shaped stack (630) within which are moulded a plurality of integrated circuit dies, the stack having a lower face (650) with a plurality of electrical connections provided thereon; electroless metal plating the stack to deposit a metallic layer (710) on a side face of the stack; selectively removing a portion of the metallic layer on the side face of the stack to form a plurality of conductive tracks (740) along the side face, the conductive tracks electrically connecting each of the integrated circuit dies to a selection of the electrical connections on the lower face of the stack, wherein the step of selectively removing a portion of the metallic layer comprises sawing a plurality of grooves (730) along the side face of the stack, the grooves extending between an upper face and the lower face of the stack.

## Description

The invention relates to forming electrical connections on integrated circuit packages, and in particular to methods of providing electroless metal plated connections on 3-dimensional stacks of integrated circuit packages.

Integrated circuits are most commonly manufactured by techniques that rely on successive 2-dimensional patterning processes, resulting in integrated circuit (IC) dies. The dies are packaged, typically in a mouldable composition such as an epoxy resin, to protect the sensitive components from external environments in use. This process results in integrated circuit chips having a largely planar construction. Stacking techniques may be used to increase the density of chips in a given volume, for example by stacking circuit boards on which the chips are mounted.

Further improvements in density can be provided by stacking the dies themselves in a 3-dimensional integrated circuit package, resulting in cuboid-shaped packages that can be compatible with existing surface mounting techniques such as BGA (Ball Grid Array) and LGA (Land Grid Array) connections. A problem with such packages, however, is that of being able to redistribute electrical connections to the IC dies in successive layers of the package. For reasons of economies of scale, each stack of dies is typically required to be cut from a stack of wafers each of which is made up of a 2-dimensional array of dies. This cutting process prevents electrical connections from being made between the dies to a base layer of the stack (e.g. for connection to a motherboard via a BGA) until after the stacks are divided from the stack of wafers. A method is therefore required to allow electrical connections to be made along one or more side faces of the stacks after division.

Advantages of forming 3-dimensional stacks of IC dies in a single package include the absence of the need for wire bonds and the capability of different die sizes to be stacked internally while retaining a similar outer appearance and electrical layout. The electrical layout of a stack can be routed via one or more side walls of the package. Although a 3-dimensional stack may add further cost to the overall packaging process, this can outweigh the alternative costs involved in stacking packages on circuit boards, as well as result in a substantial overall saving in total volume for a given function.

To form the required electrical layout on a 3-dimensional stack, a technique of applying electrical connection traces along the side faces of the stack is required. Various techniques may be possible, one of which is that of electroless metal plating, being a well-known technique for depositing conductive metallic coatings on non-conductive, as well as conductive, substrates. This plating technique can be used to apply electrical connections on a 3-dimensional stack by applying an overall metallic coating followed by a patterning technique such as laser patterning to form individual traces. Laser patterning is, however, problematic due to i) being expensive; ii) tending to result in peeling of the deposited metallic layer; and iii) penetration of the laser into the intermediate layers of the stack (e.g. glue or foil layers), causing defects.

It is an object of the invention to address one or more of the above mentioned problems, to provide an electrical routing solution for a 3-dimensional stack of IC dies in a single package.

According to a first aspect of the invention there is provided a method of forming electrical connections on an integrated circuit package, the method comprising:
providing a cuboid-shaped stack within which is moulded a plurality of integrated circuit dies, the stack having a lower face with a plurality of electrical connections provided thereon;
electroless metal plating the stack to deposit a metallic layer on a side face of the stack; and
selectively removing a portion of the metallic layer on the side face of the stack to form a plurality of conductive tracks along the side face, the conductive tracks electrically connecting each of the integrated circuit dies to a selection of the electrical connections on the lower face of the stack,
wherein the step of selectively removing a portion of the metallic layer comprises sawing a plurality of grooves along the side face of the stack, the grooves extending between an upper face and the lower face of the stack.

By using a sawing process to form the individual conductive tracks along the side wall(s) of the stack, the invention overcomes the problems associated with laser machining. In addition, a finer pitch is possible by using a sawing process, and the invention has the further advantage that the same or similar equipment can be used for package singulation (i.e. dividing the stacks from a stacked wafer package) as for the metal patterning process.

According to a second aspect of the invention there is provided an integrated circuit package comprising a cuboid-shaped stack within which are moulded a plurality of integrated circuit dies, the stack having a lower face with a plurality of electrical connections provided thereon, a plurality of tracks being provided along a side face of the stack to connect the plurality of electrical connections with each of the plurality of integrated circuit dies, each track separated from adjacent tracks by a groove extending between an upper face and the lower face of the stack.

The invention will now be described by way of example with reference to the appended drawings in which:
figures 1a to 1d illustrate in schematic cross-section a process for providing a wafer comprising an array of semiconductor dies;
figure 2 is a plan view of an exemplary wafer resulting from the process of figures 1 a to 1 d;
figures 3a and 3b are schematic cross-sectional and plan views of a portion of a wafer comprising an array of dies;
figure 4a is a schematic cross-sectional view of a wafer having electrical fan-out connections;
figure 4b is a schematic cross-sectional view of the wafer of figure 4a upon separation from a support substrate;
figures 5a to 5d are schematic cross-sectional views illustrating a process of building up a stack of wafers;
figure 6 is a schematic cross-sectional view of a stack of wafers after division into individual stacks;
figures 7a to 7c illustrate in schematic perspective views a process of providing conductive tracks along side faces of a stack; and
figure 8 is a schematic cross-sectional view of a stack mounted on a PCB.

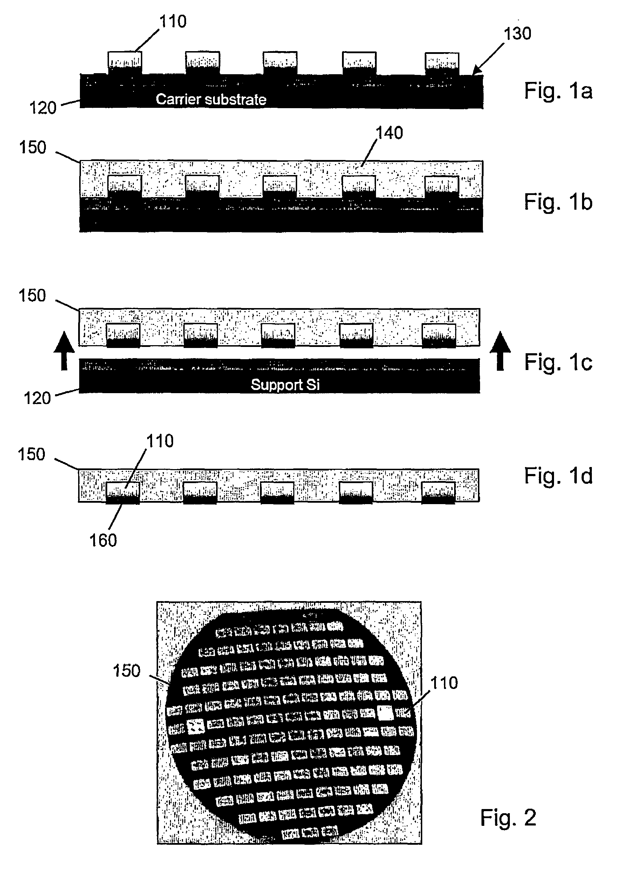

Figures 1a to 1d illustrate an exemplary process for obtaining a wafer-scale chip package. As shown in figure 1a, in a first step individual semiconductor dies (or chips) 110 are placed on a carrier substrate 120, the chips being attached to the carrier substrate 120 by means of an temporary bonding layer, for example in the form of a double-side adhesive tape 130. Preferably each die is tested before being placed on the carrier substrate 120, so that only functioning dies are used.

In a second step, shown in figure 1b, the dies 110 are moulded into a wafer 150 by applying a moulding compound 140 around the dies. The underside of each die 110, on which electrical connections are to be made, is protected from the moulding compound 140 by being attached to the carrier substrate 120.

In a third step, shown in figure 1c, the wafer 150 is separated from the carrier substrate 120. The wafer 150, with electrical connections on the exposed surfaces 160 of the now embedded dies 110 (figure 1d), can then be handled as a single unit during subsequent processing steps. A plan view of an exemplary wafer 150, in which a 2-dimensional array of dies 110 is embedded, is shown in figure 2.

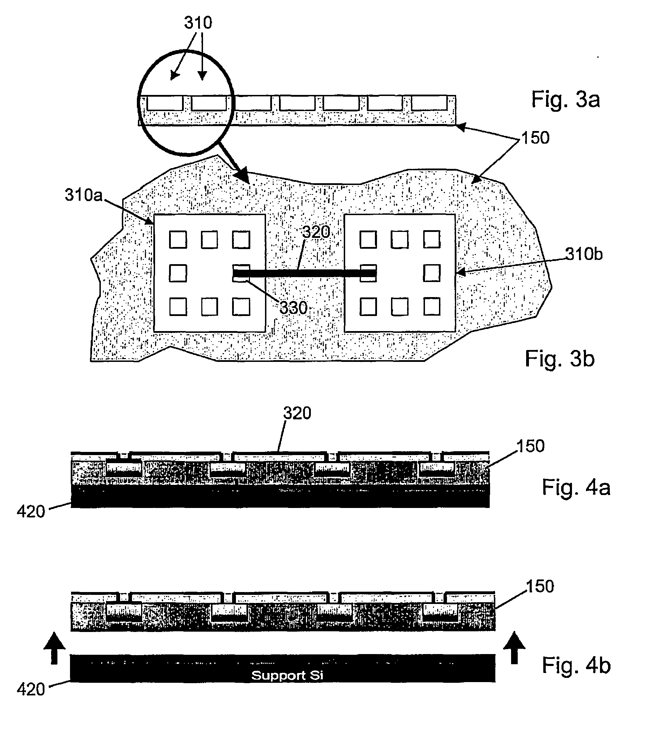

Figures 3a and 3b illustrate schematically a subsequent step performed on each wafer, which provides fan-out electrical connection traces from each die 110. Electrical connections between adjacent dies 310a, 310b are deposited on a surface of the wafer 150, one such connection 320 being shown in figure 3b. Each connection 320 connects a die pad 330 of one die 310a to that of another die 310b. These connections 320 are also shown in cross-section in figure 4a, which illustrates the wafer 150 now attached to a carrier substrate 420 with the exposed surfaces on the dies 310 face-up to allow the connections 320 to be applied. The wafer 150 is then separated from the carrier substrate 420 after the connections are applied (figure 4b).

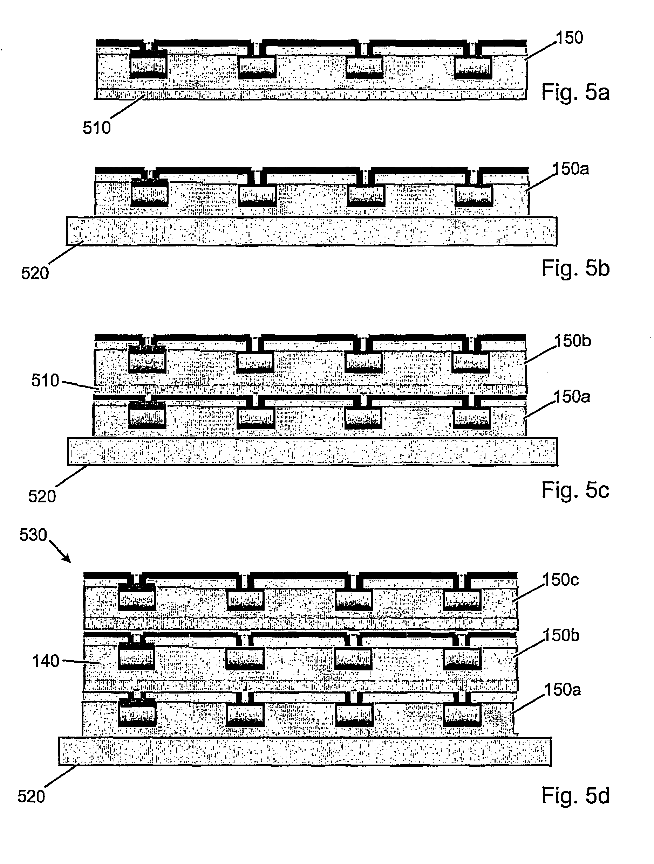

Figures 5a to 5d illustrate further processing stages involved in creating a 3-dimensional stack of wafers. Shown in figure 5a, a glue layer 510 is applied to a face of each wafer 150. A first wafer 150a is attached to a carrier substrate 520 (figure 5b). A second wafer 150b is then attached to the first wafer 150a with the glue layer 510 (figure 5c). The process is repeated (figure 5d) until sufficient layers have been assembled. A 3-dimensional stack 530 is then formed in which each layer 150a, 150b, 150c comprises a 2-dimensional array of dies that are electrically connected within the plane of the layer but the layers are electrically isolated from each other by the compound moulding material 140 and glue layers 510.

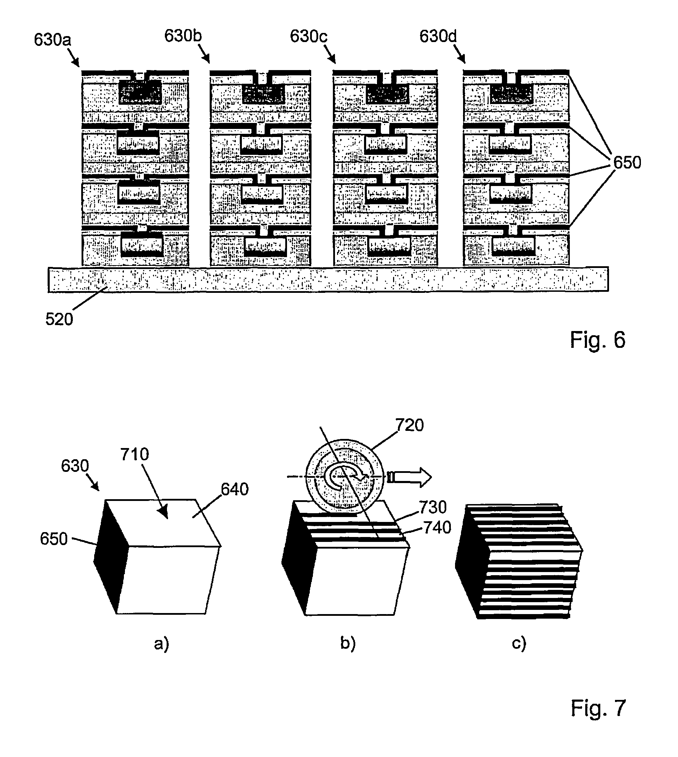

As shown in figure 6, the 3-dimensional stack 530, in this case comprising four wafer layers, is then divided into individual stacks 630a-d in a machining operation. The machining operation preferably comprises a series of sawing operations, for example using a computer-controlled grinding disc to accurately saw through the wafers between adjacent dies. This machining operation exposes electrical connections 650 on side faces of each of the stacks 630a-d. The individual stacks 630a-d can then be removed from the carrier substrate 520.

figures 7a to 7c illustrate schematically a subsequent series of processing steps to form electrical connections between each layer of the individual stacks 630. The stacks 630 are first subjected to an electroless metal plating process, which deposits a metallic layer 710 over at least one side face 640 of the stack 630. This process may be performed while the stacks 630a-d are on the carrier substrate 520, so that electrical output connections on the lower face 650 of each stack are protected.

A particular preferred material for use as the deposited metal layer 710 is a nickel and gold composition (Ni-Au). Various processes for electroless metal deposition are known in the art, and need not be described here in detail. Further information regarding an exemplary electroless Ni plating process suitable for use with the invention is disclosed by W. Riedel in "Electroless Nickel Plating", ASM International, 1991.

After electroless plating, portions of the metallic layer 710 are selectively removed from the side face 640 of the stack 630 by means of a sawing operation (figure 7b). A rotating grinding disc 720 may be used to machine narrow grooves 730 along the side face 640 of the stack, forming a plurality of conductive tracks 740 along the side face. The remaining metallic layer, now in the form of conductive tracks extending between an upper surface and the lower surface 650 of the stack 630, connects with the electrical connections 320 (figure 4a) provided on each layer of the stack, so that a connection can be made from the lower face 650 of the stack 630 to each of the individual dies in the stack (figure 7c).

A positioning precision of around 7µm is currently possible for the selective sawing step, allowing conductive tracks with a pitch of the order of 25 µm to be produced. The selective sawing process results in several advantages over other techniques such as laser patterning. Firstly, the same equipment can be used that may already be in place for dividing the packages from a stack of wafers, therefore requiring only minor reconfigurations in the process line. Secondly, fine machining by sawing is a well known and mature processing technique, and can achieve high levels of accuracy with low set-up costs as compared with laser machining. Thirdly, sawing can result in a finer scale pitch, and with less resulting surface and sub-surface damage, than laser machining.

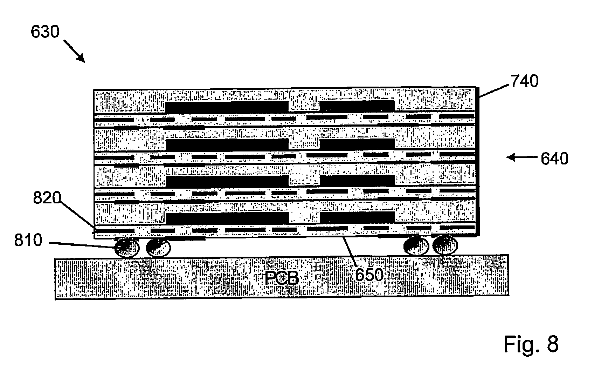

The finished form of a stack 630 is shown schematically in figure 8, as attached to a printed circuit board (PCB) by a ball grid array 810. The lower face 650 of the stack 630 provides the electrical connections to the PCB via a ball grid array 810. A redistribution layer 820 on the lower face 630 of the stack, allows for appropriate connections on the lower surface to be made to one or more of the side faces 640, on which are provided the conductive tracks 740 resulting from the preceding stages. With appropriate configuration of connections, each layer of the stack 630, which may be provided with different fan-out connections to connect with different conductive tracks along one or more side faces of the stack, can be addressed through the connections provided on the lower face 650.

Other embodiments are intentionally within the scope of the invention as defined by the appended claims.

## Claims

1. A method of forming electrical connections on an integrated circuit package, the method comprising:
providing a cuboid-shaped stack within which are moulded a plurality of integrated circuit dies, the stack having a lower face with a plurality of electrical connections provided thereon;
electroless metal plating the stack to deposit a metallic layer on a side face of the stack; and
selectively removing a portion of the metallic layer on the side face of the stack to form a plurality of conductive tracks along the side face, the conductive tracks electrically connecting each of the integrated circuit dies to a selection of the electrical connections on the lower face of the stack,
wherein the step of selectively removing a portion of the metallic layer comprises sawing a plurality of grooves along the side face of the stack, the grooves extending between an upper face and the lower face of the stack.

2. The method of claim 1 comprising the preceding steps of:
providing a plurality of wafers, each wafer comprising a planar array of integrated circuit dies;
applying electrical connection traces to a first face of each wafer;
stacking the plurality of wafers to form a 3 dimensional array of integrated circuit dies; and
dividing the array into a plurality of said cuboid-shaped stacks by cutting the stack of wafers between adjacent integrated circuit dies.

3. The method of claim 1 wherein the metallic layer comprises nickel and gold.

4. The method of claim 1 wherein the step of electroless metal plating is carried out prior to removal of the stack from a carrier substrate on which a plurality of said stacks are mounted.

5. An integrated circuit package comprising a cuboid-shaped stack within which are moulded a plurality of integrated circuit dies, the stack having a lower face with a plurality of electrical connections provided thereon, a plurality of tracks being provided along a side face of the stack to connect the plurality of electrical connections with each of the plurality of integrated circuit dies, each track separated from adjacent tracks by a groove extending between an upper face and the lower face of the stack.

6. The integrated circuit package of claim 5 wherein the plurality of tracks are formed of an electroless deposited metal layer.

7. The integrated circuit package of claim 6 wherein the metal layer comprises nickel and gold.
